# EUROPÄISCHE PATENTSCHRIFT

(11) **EP 0 790 761 B1**
(45) Veröffentlichungstag und Bekanntmachung des Hinweises auf die Patenterteilung: **21.07.1999**
(21) Anmeldenummer: 97101156.4
(22) Anmeldetag: 24.01.1997
(51) Int. Cl.: H05K 7/14, H05K 9/00

(54) **Anordnung zur voreilenden Erdung**
Assembly for a rash grounding
Assemblage pour une mise immédiate à la masse

(30) Priorität: 12.02.1996 DE 29602428 U
(43) Veröffentlichungstag der Anmeldung: 20.08.1997
(73) Patentinhaber: Knürr-Mechanik für die Elektronik AG, D-81829 Munchen (DE)
(72) Erfinder: Heckner, Helmut, 94424 Vilshofen (DE); Spateneder, Werner, 84347 Pfarrkirchen (DE); Rickinger, Thomas, 94424 Arnstorf (DE); Flamme, Hans, 82008 Unterhaching (DE); Eder, Petra, 94086 Griesbach (DE); Neblich, Josef, 85456 Wartenberg (DE)
(74) Vertreter: Heim, Hans-Karl, Dipl.-Ing.

(56) Entgegenhaltungen:
- EP-A- 0 264 686
- WO-A-87/05776
- DE-A- 4 141 559
- DE-U- 9 217 302
- GB-A- 2 142 783
- US-A- 5 533 631

## Beschreibung

Die Erfindung betrifft eine Anordnung zur voreilenden Erdung einer Steckbaugruppe, beispielsweise einer Leiterplatte, einer Steckplatte, eines Steckblockes oder einer Kassette, während des Einschiebens in Führungsschienen eines Gehäuses oder eines Baugruppenträgers bis zum Steckvorgang mit einer Steckbaugruppe und mit einem Kontaktelement gemäß dem Oberbegriff des Anspruchs 1.

Neben der Schutzerdung eines Gehäuses oder Baugruppenträgers, mit welcher leicht berührbare inaktive Metallteile mit einem Schutzleiter verbunden werden, ist eine Erdung auch beim Steckvorgang einer Steckbaugruppe, welche mit einer Spannung von 50 V kontaktiert wird, erforderlich.

Es ist bekannt, Steckverbinder mit einem voreilenden Erdkontakt auszurüsten und über diesen Erdkontakt eine Verbindung einer Steckbaugruppe mit dem Schutzleiter des Baugruppenträgers herzustellen. Anordnung und konstruktive Ausbildung des Erdkontaktes sollten eine elektrische Verbindung ermöglichen, noch bevor sich die anderen spannungsführenden Kontakte in einem rückseitigen Bereich der Steckbaugruppe und des Gehäuses oder Baugruppenträgers berühren können. Beim Ziehen einer Baugruppe muß die elektrische Verbindung des voreilenden Erdkontaktes als letzte unterbrochen werden.

Eine bekannte Schutzleiterverbindung sieht den Einsatz einer Kontaktfeder im Bereich einer leitfähigen Führungsschiene eines Baugruppenträgers vor. Die Kontaktfeder wird in die Führungsschiene, die in der Regel aus einem Kunststoff hergestellt ist, eingesetzt und stellt beim Einschieben einer Steckbaugruppe eine elektrische Verbindung her. Bei einer aus der GB 2 142 783 A bekannten Anordnung ist ein Kontaktelement, welches einen Klemmbereich und einen Haltebereich aufweist, in Einschubrichtung einer Leiterplatte nach einer Führungsschiene und vor den rückseitigen Steckkontakten angeordnet, um eine Schutzerdung vor Verbindung der Steckkontakte zu gewährleisten.

Nachteilig ist bei der bekannten Ausbildung, daß das Kontaktelement innerhalb oder nach der Führungsschiene angeordnet ist und beim Einschieben nicht in jedem Fall die erforderliche voreilende Schutzerdung gewährleistet ist.

Der Erfindung liegt die **Aufgabe** zugrunde, eine Anordnung mit einem kostengünstig herstellbaren und montierbaren Kontaktelement zu schaffen, welche eine sichere und wirkungsvolle Schutzerdung und eine sehr frühzeitige Ableitung elektrostatischer Aufladungen beim Steckvorgang von Steckbaugruppen gewährleistet.

Erfindungsgemäß wird die Aufgabe durch die Merkmale des Anspruchs 1 gelöst. Zweckmäßige und vorteilhafte Ausgestaltungen sind in den Unteransprüchen und in der Figurenbeschreibung enthalten.

Ein Grundgedanke der Erfindung besteht darin, zur voreilenden Erdung von Steckverbindern ein Kontaktelement mit einem Klemmbereich und einem Haltebereich einzusetzen, welches mit dem Haltebereich, welcher in Einschubrichtung vor dem Klemmbereich liegt, an einem frontseitigen Querprofil des Gehäuses oder Baugruppenträgers an- oder aufliegt und insbesondere an diesem gehalten wird. Dabei wird eine Außenkante des frontseitigen Querprofils von dem Haltebereich überdeckt und eine äußerst frühzeitige Schutzerdung und Ableitung elektrostatischer Aufladungen erreicht.

Erfindungsgemäß weist eine Anordnung zur voreilenden Erdung einer Steckbaugruppe, beispielsweise einer Leiterplatte, einer Steckplatte, eines Steckblocks oder einer Kassette, beim Einschub in Führungsschienen eines Gehäuses oder Baugruppenträgers im Bereich einer Führungsschiene, welche an einem horizontal und quer zur Einschubrichtung angeordneten frontseitigen Querprofil des Gehäuses oder Baugruppenträgers befestigt ist, ein Kontaktelement auf, welches wenigstens teilweise in Einschubrichtung der Steckbaugruppe vor der Führungsschiene angeordnet ist und mit dem Haltebereich bis an einen Frontbereich des frontseitigen Querprofils reicht.

Der Klemmbereich mit horizontal ausgerichteten Kontaktleisten und der Haltebereich des Kontaktelementes sind im eingebauten Zustand im wesentlichen im Bereich des frontseitigen Querprofils des Gehäuses oder Baugruppenträgers und in Einschubrichtung vor der Führungsschiene angeordnet, wobei ein Klemmbogenbereich der Kontaktleisten oberhalb der Führungsschiene verlaufen kann.

Zur Halterung weist das Kontaktelement an dem Haltebereich wenigstens einen in Einschubrichtung vorderen Quersteg auf, welcher bevorzugt komplementär zu einer Nut im Frontbereich des Querprofils des Gehäuses oder Baugruppenträgers ausgebildet ist. Vorteilhaft ist ein weiterer, beispielsweise in Einschubrichtung hinterer Quersteg am Haltebereich, der ebenfalls mit einer Nut des frontseitigen Querprofils zusammenwirken kann.

Der Haltebereich ist im wesentlichen horizontal und als eine ebene Anlagefläche ausgebildet, welche auf einem komplementären Profilbereich des frontseitigen Querprofils aufliegt. Im Bereich einer oberen Außenkante des Querprofils befindet sich bei einem eingebauten Kontaktelement eine Erhöhung des Haltebereichs, die insbesondere bogenförmig ausgebildet sein kann. Dieser Teil des Haltebereichs dient zur Abstützung einer Steck- und Ziehhilfe und verbessert deren Hebelwirkung und damit das Stecken und Ziehen von Leiterplatten und anderen Steckbaugruppen.

Das in einer Seitenansicht als auseinandergezogenes Z ausgebildete Kontaktelement weist zwischen dem als unteren Querbalken angeordneten Haltebereich und den federartigen Kontaktleisten des Klemmbereichs, welche den oberen Querbalken darstellen, Verbindungsstege auf, welche nahezu vertikal, d.h. parallel zu Seitenflächen einer Steckbaugruppe, angeordnet sind und mit einem in Einschubrichtung hinteren Haltebereich einen U-förmigen Aufnahmebereich für eine Leiterplatte oder eine Seitenkante einer Steckbaugruppe bilden. In diesem Aufnahmebereich kann auch ein Bereich einer Steck- und Ziehhilfe während ihrer Betätigung bewegt werden.

Der Klemmbereich des Kontaktelementes ist derart ausgebildet, daß eine Leiterplatte oder eine Seitenkante eines Steckblocks oder einer Kassette aufgenommen und geführt ist, wobei insbesondere eine beidseitige Anlage an einer Leiterplatte bzw. an einer Seite eines Steckblocks oder einer Kassette gewährleistet ist.

Die zwei Kontaktleisten des Klemmbereichs, welche federartig ausgebildet sind und parallel zueinander verlaufen, weisen zweckmäßigerweise einen Abstand auf, der der Dicke einer Leiterplatte oder einer Seite einer Steckbaugruppe, Kassette etc. entspricht.

Eine besonders wirkungsvolle elektrische Verbindung wird mit Klemmbögen erreicht, die in Einschubrichtung rückseitig und an den zum Gehäuseinneren gerichteten Enden der Kontaktleisten ausgebildet und zueinander gerichtet sind.

Indem das erfindungsgemäße Kontaktelement bis an oder über eine Außenkante des frontseitigen Querprofils des Gehäuses oder Baugruppenträgers reicht, ist eine wirkungsvolle und frühzeitige voreilende Erdung gewährleistet. Beim Ziehen von Steckbaugruppen wird die elektrische Verbindung des voreilenden Kontaktelementes als letzte unterbrochen. Außerdem ist eine frühzeitige Ableitung elektrostatischer Aufladungen von Leiterplatten, Steckbaugruppen und deren Frontplatten gewährleistet.

Darüberhinaus ermöglicht die konstruktive Ausbildung des einteiligen Kontaktelementes eine kostengünstige Fertigung und Montage. Beispielsweise kann das Kontaktelement durch einen Stanz- und Biegeprozeß hergestellt werden.

Zweckmäßigerweise ist das Kontaktelement aus einem leitfähigen Material mit guter Federwirkung, z.B. aus Kupfer oder einer entsprechenden Legierung, hergestellt.

Die Erfindung wird nachstehend anhand einer Zeichnung weiter erläutert; in dieser zeigen in einer stark schematisierten Weise:
- Fig. 1: in einer Seitenansicht eine ausschnittsweise Darstellung eines Baugruppenträgers im Bereich eines unteren, frontseitigen Querprofils, jedoch ohne Führungsschiene und
- Fig. 2: eine perspektivische Darstellung des erfindungsgemäßen Kontaktelementes.

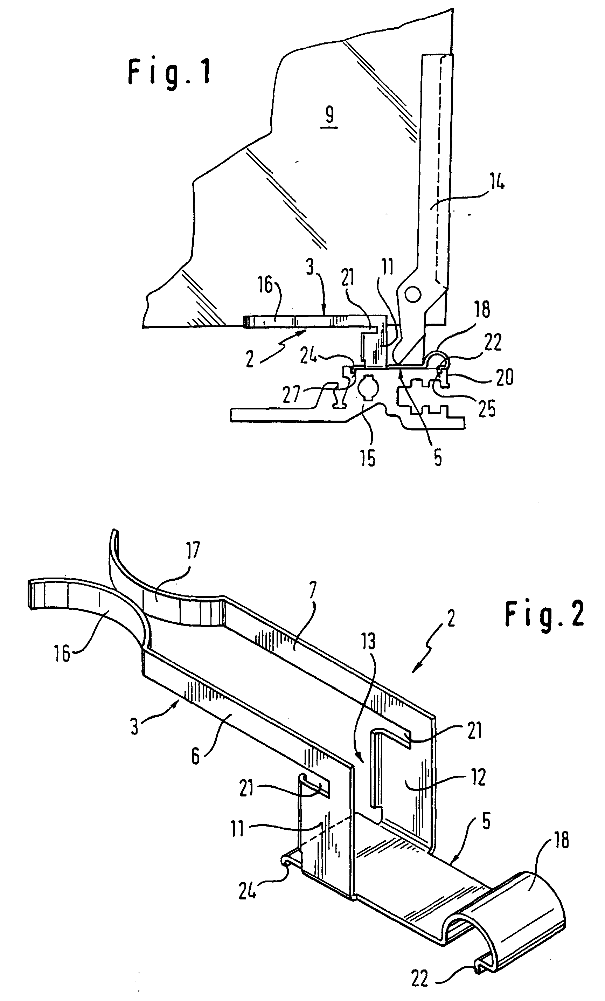

In Fig. 1 ist ein Kontaktelement 2 zur voreilenden Erdung eines Steckverbinders einer Leiterplatte 9 als Steckbaugruppe dargestellt.

Das Kontaktelement 2 ist an einem unteren frontseitigen Querprofil 15 eines Baugruppenträgers (nicht dargestellt) gehalten und reicht mit einem Haltebereich 5 und einer an dessen freiem, in Einschubrichtung vorderen Ende ausgebildeten bogenförmigen Erhöhung bzw. einem Stützbogen 18 bis an eine obere Außenkante oder an einen Frontbereich 20 des frontseitigen, unteren Querprofils 15.

Die bogenförmige Erhöhung oder der Stützbogen 18 mit einem etwa halbkreisförmigen Querschnitt dient als Abstützpunkt für eine Steck- und Ziehhilfe 14 beim Einschieben der Leiterplatte 9 in einen Klemmbereich 3 des Kontaktelementes 2 und danach in eine Führungsschiene (nicht dargestellt), wobei eine Messerleiste der Leiterplatte und eine Federleiste des Baugruppenträgers (nicht dargestellt) verbunden werden.

Aus Fig. 1 geht die Fixierung des Kontaktelementes 2 an dem frontseitigen, senkrecht zur Einschubrichtung angeordneten Querprofil 15 eines Gehäuses oder Baugruppenträgers mit an dem Haltebereich 5 ausgebildeten Querstegen 22, 24, welche mit komplementär ausgebildeten Nuten 25, 27 des Querprofils 15 zusammenwirken, hervor. Ausbildung und Anordnung eines in Einschubrichtung vorderen Querstegs 22 und eines hinteren Querstegs 24 sind auch aus Fig. 2 erkennbar. Das Kontaktelement 2 ist mit dem in Einschubrichtung vorderen Haltebereich 5 vor der Führungsschiene (nicht dargestellt) und auf dem frontseitigen Querprofil 15 aufliegend angeordnet.

Die jeweils endseitige und horizontale Ausrichtung der Querstege 22, 24 an einem weitgehend horizontal ausgerichteten Haltebereich 5 ermöglicht eine Fixierung des Kontaktelementes 2 durch Einrasten und Verspannen des Haltebereichs 5 zwischen den Nuten 25, 27, wobei die Nut 25 nahe dem Frontbereich 20 und die Nut 27 in einem in Einschubrichtung hinteren Bereich des frontseitigen Querprofils 15 angeordnet sind und durch den Stützbogen 18 ein weiterer Toleranzausgleich gegeben ist.

Aus der perspektivischen Darstellung des Kontaktelementes 2 in Fig. 2 ist dessen Ausbildung als auseinandergezogenes Z erkennbar.

Der Haltebereich 5 weist an einem zum Gehäuseinneren (nicht dargestellt) gerichteten, in Einschubrichtung rückseitigen Bereich Verbindungsstege 11, 12 auf, welche vertikal ausgerichtet, d.h. von dem Haltebereich 5 nach oben gerichtet sind. Die Verbindungsstege 11, 12 und der Haltebereich 5 im Bereich der Verbindungsstege 11, 12 bilden eine U-förmige Aufnahmeöffnung oder Aufnahmebereich 13, welcher beispielsweise während des Einschubs und während des Ziehens einer Leiterplatte 9 einen Bereich einer Steck- und Ziehhilfe 14 (Fig. 1) aufnehmen kann.

Eine leitfähige Verbindung zwischen der Leiterplatte 9 und dem Kontaktelement 2 wird, wie Fig. 1 deutlich zeigt, durch den Klemmbereich 3 realisiert. Der Klemmbereich 3 weist zwei Kontaktleisten 6, 7 zur Anlage an beiden Seitenflächen der Leiterplatte 9 auf. Mit in Einschubrichtung rück- und endseitig ausgebildeten bogenförmigen Bereichen oder Klemmbögen 16, 17, welche zueinander gerichtet sind, wird eine Klemmführung der Leiterplatte 9 während des Einschiebens und Ziehens und eine besonders sichere Schutzerdung erreicht.

Der Abstand zwischen den Kontaktleisten 6, 7 und den federnd spreizbaren Klemmbögen 16, 17 entspricht den Abmessungen einer Leiterplatte oder einer Seite einer Kassette oder eines Steckblocks.

Vorteilhaft wirken sich Ausnehmungen 21 in einem Verbindungsbereich zwischen den Verbindungsstegen 11, 12 und den Kontaktleisten 6, 7 aus. Die Ausnehmungen 21 verbessern die Federwirkung des Klemmelementes 2 in horizontaler und vertikaler Richtung.

## Patentansprüche

1. Anordnung zur voreilenden Erdung einer Steckbaugruppe (9), insbesondere einer Leiterplatte, Steckplatte, eines Steckblocks oder einer Kassette, beim Einschub in Führungsschienen eines Gehäuses oder Baugruppenträgers, mit einer Steckbaugruppe (9) und mit einem Kontaktelement (2) im Bereich einer Führungsschiene, welche an einem horizontal und quer zur Einschubrichtung angeordneten frontseitigen Querprofil (15) des Gehäuses oder Baugruppenträgers befestigt ist, wobei das Kontaktelement (2) einen Klemmbereich (3) und einen Haltebereich (5) aufweist,
dadurch **gekennzeichnet**,
daß das Kontaktelement (2) wenigstens teilweise in Einschubrichtung vor der Führungsschiene angeordnet ist und mit dem Haltebereich (5) an einem Frontbereich (20) des frontseitigen Querprofils (15) anliegt.

2. Anordnung nach Anspruch 1,
dadurch **gekennzeichnet**,
daß der Haltebereich (5) zur Halterung des Kontaktelementes (2) an dem frontseitigen Querprofil (15) des Gehäuses oder Baugruppenträgers gehalten ist.

3. Anordnung nach Anspruch 1 oder 2,
dadurch **gekennzeichnet**,
daß der Haltebereich (5) des Kontaktelementes (2) wenigstens einen in Einschubrichtung vorderen Quersteg (22) aufweist und daß der vordere Quersteg (22) zum Eingriff in eine Nut (25) im Frontbereich (20) des frontseitigen Querprofils (15) des Gehäuses oder Baugruppenträgers ausgebildet ist.

4. Anordnung nach Anspruch 3,
dadurch **gekennzeichnet**,
daß am Haltebereich (5) des Kontaktelementes (2) zusätzlich ein in Einschubrichtung hinterer Quersteg (24) ausgebildet ist und daß der hintere Quersteg (24) zum Eingriff in eine rückseitige Nut (27) des frontseitigen Querprofils (15) ausgebildet ist.

5. Anordnung nach Anspruch 3 oder 4,
dadurch **gekennzeichnet**,
daß der in Einschubrichtung vordere Quersteg (22) an einer bogenförmigen Erhöhung oder einem Stützbogen (18) des Haltebereichs (5) des Kontaktelementes (2) ausgebildet ist und daß die bogenförmige Erhöhung oder der Stützbogen (18) zur Abstützung einer Steck- und Ziehhilfe (14) für die Steckbaugruppe (9) vorgesehen ist.

6. Anordnung nach einem der vorhergehenden Ansprüche,
dadurch **gekennzeichnet**,
daß das Kontaktelement (2) in Seitenansicht ein auseinandergezogenes Z ist, daß der Klemmbereich (3) den oberen Querbalken, der Haltebereich (5) den unteren Querbalken und Verbindungsstege (11, 12), welche parallel zur Steckbaugruppe (9) angeordnet sind, den Mittelbalken bilden.

7. Anordnung nach Anspruch 6,
dadurch **gekennzeichnet**,
daß der Abstand der Verbindungsstege (11, 12) des Kontaktelementes (2) der Dicke der Steckbaugruppe (9), taktelementes (2) der Dicke der Steckbaugruppe (9), z.B. einer Leiterplatte, oder einer Seite eines Steckblockes oder einer Kassette entspricht.

8. Anordnung nach einem der vorhergehenden Ansprüche,
dadurch **gekennzeichnet**,
daß die gesamte Breite des Kontaktelementes (2) die Breite der zugehörigen Führungsschiene nicht übersteigt.

9. Anordnung nach einem der vorhergehenden Ansprüche,
dadurch **gekennzeichnet**,
daß der Klemmbereich (3) des Kontaktelementes (2) zur Kontaktanlage an der Steckbaugruppe (9), z.B. einer Leiterplatte, oder an einer Seitenkante eines Steckblocks oder einer Kassette ausgebildet ist und zur beidseitigen Kontaktanlage zwei Kontaktleisten (6, 7) aufweist, welche nahezu parallel zueinander angeordnet sind.

10. Anordnung nach Anspruch 9,
dadurch **gekennzeichnet**,
daß die Kontaktleisten (6, 7) des Klemmbereichs (3) des Kontaktelementes (2) Klemmbögen (16, 17) aufweisen, welche zueinander gerichtet sind und eine Klemmführung bilden.

11. Anordnung nach Anspruch 10,
dadurch **gekennzeichnet**,
daß die Kontaktleisten (6, 7) mit in Einschubrichtung rückseitigen und federnd ausgebildeten Klemmbögen (16, 17) versehen sind.

12. Anordnung nach einem der Ansprüche 9 bis 11,
dadurch **gekennzeichnet**,
daß die Kontaktleisten (6, 7) des Klemmbereichs (3) über die Verbindungsstege (11, 12) mit dem Haltebereich (5) verbunden sind.

13. Anordnung nach einem der Ansprüche 6 bis 12,
dadurch **gekennzeichnet**,
daß die Verbindungsstege (11, 12) des Kontaktelements (2) mit einem in Einschubrichtung rückseitigen Teil des Haltebereichs (5) einen etwa U-förmigen Aufnahmebereich (13) für eine verschwenkbare Steck- und Ziehhilfe (14) bilden.

14. Anordnung nach einem der vorhergehenden Ansprüche,
dadurch **gekennzeichnet**,
daß das Kontaktelement (2) aus einem leitfähigen Material, insbesondere aus Kupfer, gefertigt ist.

15. Anordnung nach einem der vorhergehenden Ansprüche,
dadurch **gekennzeichnet**,
daß das Kontaktelement (2) einstückig ausgebildet und durch einen Stanz- und Biegeprozeß hergestellt ist.

## Claims

1. Assembly for anticipatory earthing during insertion of a plug-in unit (9), particularly a printed circuit board, breadboard, plug-in block or a cassette, in guide rails of a casing or subrack, with a plug-in unit (9) and with a contact element (2) in the vicinity of a guide rail, which is fixed to a front transverse profile (15) of the casing or subrack arranged horizontally and transversely to the insertion direction, in which the contact element (2) has a clamping area (3) and a holding area (5),
**characterized** in that
the contact element (2) is located at least partly in the insertion direction in front of the guide rail and engages with the holding area (5) on a front area (20) of the front transverse profile (15).

2. Assembly according to claim 1,
**characterized** in that
for retaining the contact element (2) the holding area (5) is held on the front transverse profile (15) of the casing or subrack.

3. Assembly according to claim 1 or 2,
**characterized** in that
the holding area (5) of the contact element (2) has at least one front crossbar (22) in the insertion direction and that the front crossbar (22) is constructed for engagement in a slot (25) in the front area (20) of the front transverse profile (15) of the casing or subrack.

4. Assembly according to claim 3,
**characterized** in that
on the holding area (5) of the contact element (2) is additionally constructed a rear crossbar (24) in the insertion direction and that the rear crossbar (24) is constructed for engagement in a rear slot (27) of the front transverse profile (15).

5. Assembly according to claim 3 or 4,
**characterized** in that
the front crossbar (22) in the insertion direction is constructed on an arcuate protuberance or a support arc (18) of the holding area (5) of the contact element (2) and that the arcuate protuberance or support arc (18) is provided for supporting a plug-in and pulling aid (14) for the plug-in unit (9).

6. Assembly according to one of the preceding claims,
**characterized** in that,
in side view, the contact element (2) is drawn apart Z and that the clamping area (3) forms the upper crossbeam, the holding area (5) the lower crossbeam and connecting webs (11, 12), which are positioned parallel to the plug-in unit (9), the central beam.

7. Assembly according to claim 6,
**characterized** in that
the spacing of the connecting webs (11, 12) of the contact element (2) corresponds to the thickness of the plug-in unit (9), e.g. a printed circuit board, or one side of a plug-in block or a cassette.

8. Assembly according to one of the preceding claims,
**characterized** in that
the total width of the contact element (2) does not exceed the width of the associated guide rail.

9. Assembly according to one of the preceding claims,
**characterized** in that
the clamping area (3) of the contact element (2) is constructed for contact engagement on the plug-in unit (9), e.g. a printed circuit board, or on one lateral edge of a plug-in block or a cassette and for bilateral contact engagement has two contact strips (6, 7), which are positioned almost parallel to one another.

10. Assembly according to claim 9,
**characterized** in that
the contact strips (6, 7) of the clamping area (3) of the contact element (2) have clamping arcs (16, 17), which are directed towards one another and form a clamping guide.

11. Assembly according to claim 10,
**characterized** in that
the contact strips (6, 7) are provided with rear, resilient clamping arcs (16, 17) in the insertion direction.

12. Assembly according to one of the claims 9 to 11,
**characterized** in that
the contact strips (6, 7) of the clamping area (3) are connected by means of the connecting webs (11, 12) to the holding area (5).

13. Assembly according to one of the claims 6 to 12,
**characterized** in that
the connecting webs (11, 12) of the contact element (2) with a rear part of the holding area (5) in the insertion direction form an approximately U-shaped reception area (13) for a pivotable plug-in and pulling aid (14).

14. Assembly according to one of the preceding claims,
**characterized** in that
the contact element (2) is made from a conductive material, particularly copper.

15. Assembly according to one of the preceding claims,
**characterized** in that
the contact element (2) is constructed in one piece and is produced by a punching and bending process.

## Revendications

1. Assemblage pour une mise immédiate à la masse d'une unité enfichable (9), en particulier d'une carte à circuit imprimé, d'une carte enfichable, d'un bloc enfichable ou d'une cassette, lors de l'insertion dans des rails de guidage d'un boîtier ou d'un support de composant, avec une unité enfichable (9) et un élément de contact (2) au niveau d'un rail de guidage, qui est fixé à un profilé transversal avant (15), horizontal et transversal au dispositif d'insertion, du boîtier ou du support de composant, l'élément de contact (2) présentant une zone de serrage (3) et une zone de fixation (5), ***caractérisé en ce que*** l'élément de contact (2) est placé au moins partiellement avant le rail de guidage dans la direction d'insertion et s'appuie avec la zone de fixation (5) contre une zone frontale (20) du profilé transversal avant (15).

2. Assemblage selon la Revendication 1, ***caractérisé en ce que*** la zone de fixation (5) destinée à fixer l'élément de contact (2) est fixée sur le profilé transversal avant (15) du boîtier ou du support de composant.

3. Assemblage selon la Revendication 1 ou 2, ***caractérisé en ce que*** la zone de fixation (5) de l'élément de contact (2) présente au moins une barre transversale (22) avant dans la direction d'insertion et ***en ce que*** la barre transversale avant (22) est conformée pour se mettre en prise dans une rainure (25) dans la zone frontale (20) du profilé transversal avant (15) du boîtier ou du support de composant.

4. Assemblage selon la Revendication 3, ***caractérisé en ce que,*** sur la zone de fixation (5) de l'élément de contact (2), il est formé de plus une barre transversale (24) arrière dans la direction d'insertion et ***en ce que*** la barre transversale arrière (24) est conformée pour se mettre en prise dans une rainure arrière (27) du profilé transversal avant (15).

5. Assemblage selon la Revendication 3 ou 4, ***caractérisé en ce que*** la barre transversale (22) avant dans la direction d'insertion est formée sur une surélévation en forme d'arc ou un arc de soutien (18) de la zone de fixation (5) de l'élément de contact (2) et ***en ce que*** la surélévation en forme d'arc ou l'arc de soutien (18) est prévu pour soutenir un accessoire d'enfichage et d'extraction (14) destiné à l'unité enfichable (9).

6. Assemblage selon l'une quelconque des Revendications précédentes, ***caractérisé en ce que*** l'élément de contact (2) est, en vue de côté, un Z étiré, ***en ce que*** la zone de serrage (3) forme la barre transversale supérieure, la zone de fixation (5) forme la barre transversale inférieure et des barres de liaison (11, 12) qui sont placées parallèlement à l'unité enfichable (9) forment la barre intermédiaire.

7. Assemblage selon la Revendication 6, ***caractérisé en ce que*** la distance entre les barres de liaison (11, 12) de l'élément de contact (2) correspond à l'épaisseur de l'unité enfichable (9), par exemple d'une carte à circuit imprimé, ou d'un côté d'un bloc enfichable ou d'une cassette.

8. Assemblage selon l'une quelconque des Revendications précédentes, ***caractérisé en ce que*** la largeur totale de l'élément de contact (2) ne dépasse pas la largeur du rail de guidage associé.

9. Assemblage selon l'une quelconque des Revendications précédentes, ***caractérisé en ce que*** la zone de serrage (3) de l'élément de contact (2) est formée pour établir un appui de contact avec l'unité enfichable (9), par exemple une carte à circuit imprimé, ou avec un bord latéral d'un bloc enfichable ou d'une cassette et présente, afin d'assurer un appui de contact des deux côtés. deux barres de contact (6, 7) qui sont disposées quasiment parallèlement l'une à l'autre.

10. Assemblage selon la Revendication 9, ***caractérisé en ce que*** les barres de contact (6. 7) de la zone de serrage (3) de l'élément de contact (2) présentent des arceaux de serrage (16, 17) qui sont dirigés l'un vers l'autre et forment une glissière de serrage.

11. Assemblage selon la Revendication 10, ***caractérisé en ce que*** les barres de contact (6. 7) sont munies d'arceaux de serrage (16, 17) arrière dans la direction d'insertion et conformés élastiques.

12. Assemblage selon l'une quelconque des Revendications 9 à 11, ***caractérisé en ce que*** les barres de contact (6, 7) de la zone de serrage (3) sont reliées à la zone de fixation (5) par les barres de liaison (11, 12).

13. Assemblage selon l'une quelconque des Revendications 6 à 12, ***caractérisé en ce que*** les barres de liaison (11, 12) de l'élément de contact (2) forment, avec une partie de la zone de fixation (5) arrière dans la direction d'insertion, une zone de réception (13) approximativement en U pour un accessoire pivotant d'enfichage et d'extraction (14).

14. Assemblage selon l'une quelconque des Revendications précédentes, ***caractérisé en ce que*** l'élément de contact (2) est fabriqué dans un matériau conducteur, en particulier du cuivre.

15. Assemblage selon l'une quelconque des Revendications précédentes, ***caractérisé en ce que*** l'élément de contact (2) est conformé d'une seule pièce et est fabriqué par un procédé d'estampage et de cintrage.
